# EUROPEAN PATENT APPLICATION

(11) **EP 4 297 075 A1**
(43) Date of publication of application: **27.12.2023**
(21) Application number: 23170147.5
(22) Date of filing: 26.04.2023
(51) Int. Cl.: H01L 21/8238, H01L 27/092, H01L 29/04, H01L 29/775

(54) **MOBILITY IMPROVEMENT IN GATE ALL AROUND TRANSISTORS BASED ON SUBSTRATE ORIENTATION**

(30) Priority: 23.06.2022 US 202217847555
(71) Applicant: INTEL Corporation, Santa Clara, CA 95054 (US)
(72) Inventor: KAVALIEROS, Jack, Portland, 97229 (US); RADOSAVLJEVIC, Marko, Portland, 97229 (US); GLASS, Glenn, Portland, 97229 (US); BUDREVICH, Aaron, Portland, 97229 (US); AGRAWAL, Ashish, Hillsboro, 97124 (US); SUNG, Seung Hoon, Portland, 97229 (US); BOWONDER, Anupama, Portland, 97229 (US); PAUL, Rajat, Portland, 97229 (US); GUHA, Biswajeet, Hillsboro, 97124 (US); NAHM, Rambert, Beavertown, 97006 (US); MERRILL, Devin, McMinnville, 97128 (US); ONI, Adedapo, North Plains, 97133 (US); HSU, William, Portland, 97229 (US); GHOSE, Susmita, Hillsboro, 97124 (US); SUBRAMANIAN, Shruti, Hillsboro, 97124 (US); BRIGGS, Natalie, Hillsboro, 97124 (US); RAMAMURTHY, Rahul, Hillsboro, 97123 (US); TSENG, Hsin-Ying, Hillsboro, 97006 (US)
(74) Representative: HGF

(57) **Abstract**

Techniques are provided herein to form semiconductor devices on a substrate with an alternative crystallographic surface orientation. The techniques are particularly useful with respect to gate-all-around and forksheet transistor configurations. A substrate having a (110) crystallographic surface orientation forms the basis for the growth of alternating types of semiconductor layers. Both n-channel and p-channel transistors may be fabricated using silicon nanoribbons formed from some of the alternating semiconductor layers. The crystallographic surface orientation of the Si nanoribbons will reflect the same crystallographic surface orientation of the substrate, which leads to a higher hole mobility across the Si nanoribbons of the p-channel devices and an overall improved CMOS device performance.

## Description

### FIELD OF THE DISCLOSURE

The present disclosure relates to integrated circuits, and more particularly, to semiconductor devices formed on substrates having different orientations.

### BACKGROUND

As integrated circuits continue to scale downward in size, a number of challenges arise. For instance, reducing the size of memory and logic cells or otherwise increasing transistor density is becoming increasingly more difficult. Different transistor architectures that maximize available semiconductor surfaces to form active channels have been contemplated, including nanowire, nanoribbon or nanosheet (gate-all-around) and forksheet architectures. However, such architectures come with drawbacks with regards to carrier mobility that can be achieved across the active channels. Accordingly, there remain a number of non-trivial challenges with respect to forming certain transistor structures while maintaining a high carrier mobility along the semiconductor channels.

### BRIEF DESCRIPTION OF THE DRAWINGS

Figure 1A is a cross-sectional view of an example integrated circuit having semiconductor devices on a substrate with a (110) crystallographic surface orientation, in accordance with an embodiment of the present disclosure.
Figure 1B is an orthogonal cross-sectional view of one of the semiconductor devices in Figure 1A, in accordance with an embodiment of the present disclosure.
Figures 2A - 2H are cross-section views that collectively illustrate various stages in an example process for forming semiconductor devices on a substrate having a (110) crystallographic surface orientation, in accordance with some embodiments of the present disclosure.
Figures 3A - 3E are cross-section views that collectively illustrate various stages in an example process for forming other semiconductor devices on a substrate having a (110) crystallographic surface orientation, in accordance with some embodiments of the present disclosure.
Figure 4 illustrates cross-section views of source and drain regions grown over a (100) substrate vs. a (110) substrate, in accordance with some embodiments of the present disclosure.
Figure 5 illustrates a cross-section view of a chip package containing one or more semiconductor dies, in accordance with some embodiments of the present disclosure.
Figure 6 is a flowchart of a fabrication process for forksheet semiconductor devices formed on a substrate having a (110) crystallographic surface orientation, in accordance with some embodiments of the present disclosure.
Figure 7 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may be tapered and/or have rounded corners), and some features may have surface topology or otherwise be non-smooth, given real world limitations of the processing equipment and techniques used.

### DETAILED DESCRIPTION

Semiconductor devices formed on a substrate with an alternative crystallographic surface orientation are herein described. Example devices include gate-all-around (e.g., nanoribbon) and forksheet (e.g., nanosheet) transistors. According to some embodiments, a substrate having a (110) crystallographic surface orientation forms the basis for the growth of alternating types of semiconductor layers. Both n-channel and p-channel transistors may be fabricated using silicon nanoribbons or nanosheets formed from some of the alternating semiconductor layers. The crystallographic surface orientation of the Si nanoribbons or nanosheets will reflect the same crystallographic surface orientation of the substrate, which leads to a higher hole mobility across the Si nanoribbons or nanosheets of the p-channel devices and an overall improved CMOS device performance. The techniques can be used in any number of integrated circuit applications and are particularly useful with respect to high-density transistor areas on a die such as logic and memory cells, such as those complementary metal oxide semiconductor (CMOS) cells that use gate-all-around (GAA) transistors or forksheet transistors. Numerous variations and embodiments will be apparent in light of this disclosure.

### General Overview

Gate-all-around (GAA) and forksheet device architectures have source, drain and gate structures that are isolated from the sub fin layer to reduce parallel conduction between the source/drain and the substrate and to reduce parasitic capacitance between the gate and the substrate. Usually, such transistors are formed on substrates having a (100) surface orientation. However, nanoribbon channels formed from epitaxially grown semiconductor layers on such substrates can suffer from poor hole mobility due to the crystallographic orientation of the semiconductor layers.

Thus, and in accordance with an embodiment of the present disclosure, techniques are provided herein to form semiconductor devices on a substrate having a (110) crystallographic surface orientation to provide better p-channel performance. Although the (110) surface orientation exhibits a lower electron mobility in the n-channel devices (as compared to the (100) surface orientation), a greater increase in hole mobility can be achieved such that the combined effect of using both n-channel and p-channel devices (e.g., CMOS architecture) exhibits an overall improved performance. The use of a (110) substrate allows for NMOS devices to be formed adjacent to PMOS devices with improved mobility characteristics. Further note that, although nanoribbons and nanosheets may be used in examples herein, the techniques similarly apply to other such relatively thin (pancake-like) semiconductor bodies that can be used for transistor channels. To this end, the use of nanosheet (or nanoribbon) is intended to include all such semiconductor bodies. Numerous variations and embodiments will be apparent in light of this disclosure.

According to some embodiments, the use of a (110) substrate affects the formation of various transistor structures. For example, the source and drain regions of a given device may be epitaxially grown from the exposed ends of the nanoribbons of that device. Since the nanoribbons themselves follow the crystallographic orientation of the substrate from which they nucleate, the growth profile of the source and drain regions is also affected. Thus, the source and drain regions will exhibit crystal facets having different orientations when grown over a (110) substrate as compared to source and drain regions grown over a (100) substrate.

According to an embodiment, an integrated circuit includes a substrate having a (110) crystallographic surface orientation, a semiconductor device on the substrate and having one or more bodies of semiconductor material extending in a first direction (e.g., left-to-right of page, or Y-direction) from a source region to a drain region, a first spacer structure that extends in a second direction (e.g., into and out of page, or X-direction) orthogonal to the first direction and around first ends of the one or more bodies of semiconductor material, a second spacer structure that extends in the second direction and around second ends of the one or more bodies of semiconductor material, and a gate structure around the one or more bodies of semiconductor material and between the first and second spacer structures. The source and drain regions do not have visible crystal facets along a cross-section taken through the source region and the drain region, with that cross-section extending along the first direction (Y-direction) and a third direction (e.g., bottom-to-top of page, or Z-direction). The third direction (Z-direction) is orthogonal to both the first direction (Y-direction) and the second direction (X-direction).

According to another embodiment, an integrated circuit includes a semiconductor device having one or more semiconductor nanoribbons extending in a first direction (e.g., Y-direction) between a source region and a drain region, a first spacer structure that extends in a second direction (e.g., X-direction) orthogonal to the first direction and around first ends of the one or more semiconductor nanoribbons, a second spacer structure that extends in the second direction and around second ends of the one or more semiconductor nanoribbons, and a gate structure around the one or more semiconductor nanoribbons and between the first and second spacer structures. Each of the one or more semiconductor nanoribbons has a (110) crystallographic surface orientation along surfaces that are parallel with a plane extending in the first direction and the second direction. The source region and the drain region do not have visible crystal facets along a cross-section through the source region and the drain region extending along the first direction and a third direction (e.g., Z-direction) orthogonal to both the first direction and the second direction. In a gate-all-around example, the gate structure wraps around the nanoribbons. In a forksheet example, the gate is effectively on three sides of the nanoribbons which extend horizontally (in the X-direction, in this example) from a dielectric spine, and the nanoribbons may be nanosheets, as the case may be.

According to another embodiment, a method of forming an integrated circuit includes providing a substrate having a (110) crystallographic surface orientation; epitaxially growing first material layers alternating with second material layers on the substrate, the second material layers comprising silicon (Si); forming a multilayer fin from the first material layers and the second material layers; forming sidewall spacer structures around exposed ends of the second material layers; removing the first material layers to form suspended (sometimes referred to as released) second material layers; forming source and drain regions coupled to the exposed ends of the second material layers, such that the source and drain regions do not have visible crystal facets along a cross-section parallel to a length of the suspended second material layers; and forming a gate structure around the suspended second material layers and between the sidewall spacer structures. Such a methodology can be applied to non-planar transistor configurations, such as GAA and forksheet configurations.

The techniques can be used with any type of non-planar transistors but are especially useful for nanowire and nanoribbon transistors (sometimes called GAA transistors) and forksheet transistors, to name a few examples. The source and drain regions can be, for example epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); timeof-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, TEM and/or SEM cross-sections taken across the source or drain regions along the same direction as the source-to-drain length of the nanoribbons will not have visible crystal facets owing to the growth profile of the source and drain regions on the (110) substrate. Note that nanoribbons are used in these examples, but the present description equally applies to nanosheet and forksheet configurations.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. If two materials are elementally different, then one of the material has an element that is not in the other material.

### Architecture

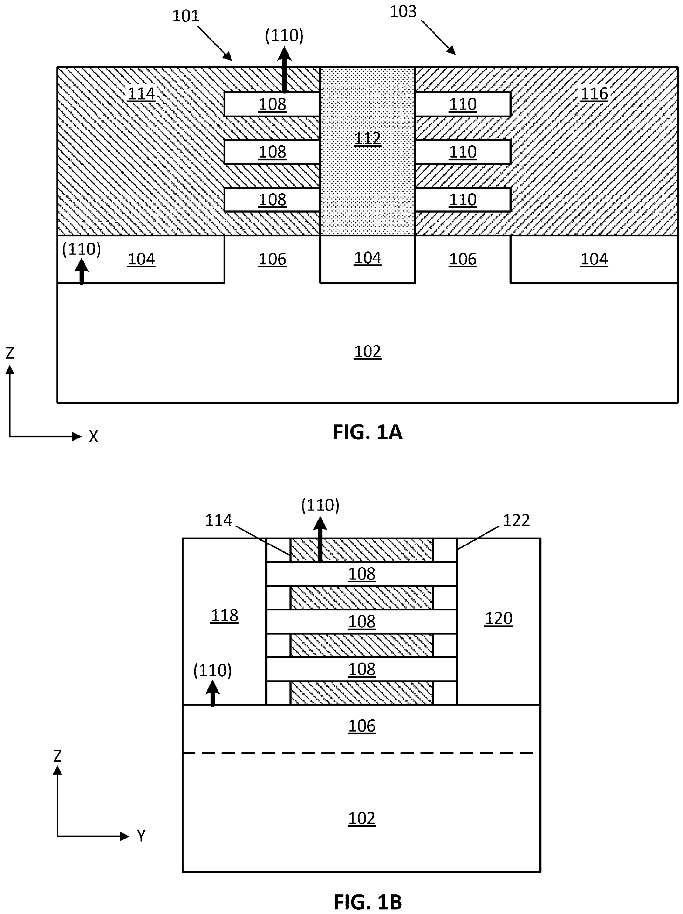

Figure 1A is a cross sectional view of a portion of an integrated circuit that includes a first semiconductor device 101 and a second semiconductor device 103 adjacent to one another in a forksheet arrangement. Figure 1B is another cross-sectional view taken across semiconductor device 101 in the orthogonal direction compared to the cross-sectional view of Figure 1A. Each of semiconductor devices 101 and 103 may be non-planar metal oxide semiconductor (MOS) transistors, such as gate-all-around (GAA) transistors, although other transistor topologies and types could also benefit from the techniques provided herein. The illustrated embodiment of Figures 1A and 1B use nanosheets in a forksheet configuration. Semiconductor devices 101 and 103 represent a portion of an integrated circuit that may contain any number of similar semiconductor devices. Figure 1B provides a cross-section view taken across first semiconductor device 101 in a first direction (e.g., Y-direction). Figure 1A is taken across first semiconductor device 101 and second semiconductor device 103 in a second direction (e.g., X-direction) while orthogonal to the first direction. Both cross-sections also extend in a third direction (e.g., Z-direction) that is orthogonal to both the first direction and the second direction.

As can be seen, semiconductor devices 101 and 103 are formed on a substrate 102. Any number of semiconductor devices can be formed on or over substrate 102, but two are used here as an example. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-oninsulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used.

The semiconductor material in each of semiconductor devices 101 and 103 may be formed from substrate 102. Semiconductor devices 101 and 103 may each include fins or semiconductor material as nanowires or nanoribbons that can be, for example, native to substrate 102 (formed from the substrate itself). Alternatively, the fins or semiconductor material can be formed of material deposited onto an underlying substrate. In one such example case, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanowires, nanosheets, or nanoribbons during a gate forming process where one type of the alternating layers are selectively etched away so as to liberate the other type of alternating layers within the channel region, so that a gate-all-around (GAA) process can then be carried out. Again, the alternating layers can be blanket deposited and then etched into fins, or deposited into fin-shaped trenches.

As can further be seen, adjacent semiconductor devices are separated by a dielectric layer 104 that may include silicon oxide. Dielectric layer 104 provides shallow trench isolation (STI) between any adjacent semiconductor devices. Dielectric layer 104 can be any suitable dielectric material, such as silicon dioxide, aluminum oxide, or silicon oxycarbonitride.

Focusing on first semiconductor device 101, but also applicable to second semiconductor device 103, first semiconductor device 101 includes a subfin region 106 and a semiconductor region that includes a plurality of nanosheets 108 above subfin region 106. According to some embodiments, subfin region 106 comprises the same semiconductor material as substrate 102 and is adjacent to dielectric layer 104. According to some embodiments, nanosheets 108 extend between a source and a drain region to provide an active region for a transistor (e.g., the semiconductor region beneath the gate). The source and drain regions are not shown in the cross-section of Figure 1A, but are seen in the cross-section view of Figure 1B where nanosheets 108 of first semiconductor device 101 extend between a source region 118 and a drain region 120 (similarly, the nanosheets 110 of semiconductor device 103 extend between corresponding source and drain regions). Any source region may also act as a drain region and vice versa, depending on the application. Figure 1B also illustrates spacer structures 122 on either end of nanosheets 108. Spacer structures 122 may include a dielectric material, such as silicon nitride. In some examples, spacer structures 122 are provided during source/drain processing. For instance, in one example case, the multilayer structure that includes nanosheets 108 is etched away in the source and drain regions (where source region 118 and drain region 120 will subsequently be formed). With the source and drain recesses open, sacrificial layers between the nanosheets 108 can be selectively recessed in the lateral direction (e.g., by an isotropic etch within the source and drain recesses, the etch being selective to nanosheets 108), and then spacer material conformally deposited (e.g., atomic layer deposition, ALD) within the recesses, so as to provide spacer structures 122 between nanosheets 108. Any excess spacer material deposited within the recesses can be removed, for instance, via a directional etch (e.g., anisotropic dry etch) or an isotropic etch, so as to provide the example structure shown in Figure 1B. Spacer structures 122 may extend in the second direction (i.e., into and out of the page).

According to some embodiments, the source and drain regions 118/120 are epitaxial regions that are provided using an etch-and-replace process. In other embodiments one or both of the source and drain regions 118/120 could be, for example, implantation-doped native portions of the semiconductor fins or substrate. Any semiconductor materials suitable for source and drain regions 118/120 can be used (e.g., group IV and group III-V semiconductor materials). The source and drain regions 118/120 may include multiple layers such as liners and capping layers to improve contact resistance. In any such cases, the composition and doping of the source and drain regions 118/120 may be the same or different, depending on the polarity of the transistors. In an example, for instance, one transistor is a p-type MOS (PMOS) transistor, and the other transistor is an n-type MOS (NMOS) transistor. Any number of source and drain configurations and materials can be used.

According to some embodiments, a dielectric spine 112 is provided between semiconductor devices 101 and 103. Dielectric spine 112 may be any suitable dielectric material, such as silicon dioxide, aluminum oxide, silicon nitride, or silicon oxycarbonitride. In some embodiments, dielectric spine 112 may include more than one material layer, such as one or more thin dielectric layers along the edges that contact nanosheets 108 of first semiconductor device 101 and nanosheets 110 of second semiconductor device 103. In general, dielectric spine 112 is in contact with both nanosheets 108 of first semiconductor device 101 and nanosheets 110 of second semiconductor device 103.

A first gate structure 114 is provided over each of nanosheets 108 and a second gate structure 116 is provided over each of nanosheets 110, according to some embodiments. Each of gate structures 114 and 116 includes both a gate dielectric around the corresponding nanoribbons and a gate electrode over the gate dielectric. The gate dielectric may include a single material layer or multiple material layers. In some embodiments, the gate dielectric includes a first dielectric layer such as silicon oxide and a second dielectric layer that includes a high-k material such as hafnium oxide. The hafnium oxide may be doped with an element to affect the threshold voltage of the given semiconductor device. In some embodiments, the gate dielectric used around nanosheets 108 has a different element doping concentration compared to the gate dielectric around nanosheets 110. According to some embodiments, the doping element used in the gate dielectric is lanthanum.

According to some embodiments, first gate structure 114 includes a first gate electrode that extends over the gate dielectric around each of nanosheets 108 and second gate structure 116 includes a second gate electrode that extends over the gate dielectric around each of nanosheets 110. Each of the gate electrodes may include any sufficiently conductive material such as a metal, metal alloy, or doped polysilicon. According to some embodiments, either gate electrode may be interrupted between any other semiconductor devices along the first direction by a gate cut structure. In some embodiments, each gate electrode includes one or more work function metals around the corresponding nanoribbons. In some embodiments, for instance, semiconductor device 101 is a p-channel device that includes a work function metal having titanium around nanosheets 108 and semiconductor device 103 is an n-channel device that includes a work function metal having tungsten around nanosheets 110. Each of the gate electrodes may also include a fill metal or other conductive material (e.g., tungsten, ruthenium, molybdenum, aluminum) around the work function metals to provide the whole gate electrode structure.

According to some embodiments, substrate 102 has a (110) crystallographic surface orientation as identified by the bold arrow normal to the surface of substrate 102. The surface orientation of the silicon lattice affects the growth profile of the semiconductor layers that are used to form each of nanosheets 108 and 110. Thus, according to some embodiments, nanosheets 108 and 110 similarly have a (110) crystallographic surface orientation along all surfaces that are parallel with the top surface of substrate 102. Put another way, nanosheets 108 and 110 have a (110) crystallographic surface orientation along all surfaces that are parallel with a plane that extends along both the first direction and the second direction. In examples where semiconductor device 101 is a p-channel device, the (110) surface orientation of nanosheets 108 provides a greater hole mobility along those surfaces that extend between source region 118 and drain region 120, according to some embodiments.

The table below shows the changes in certain device characteristics for both NMOS GAA devices and PMOS GAA devices when using a (110) substrate compared to a (100) substrate.

**Table 1: NMOS/PMOS device characteristics on (110) Si Substrate**

| **DEVICE (unstrained)** | **Δµ** | **Δ*v_{ballistic}* (∼1/m^{1/2})** | **TCAD Δeff@0.65V** |
|---|---|---|---|
| NMOS | -55% | -10% | -3.1% |
| PMOS | 143% | 46% | 25% |
| CMOS | 4.7% | 16% | 11% |

The electron carrier mobility does show a decrease in the NMOS devices on a (110) Si substrate. However, the much larger increase in hole mobility in the PMOS devices makes up for the decreased electron mobility such that the CMOS product exhibits an overall increase in carrier mobility. Similarly, the ballistic velocity of the carriers decreases for electron carriers in the NMOS devices but has a greater increase for the hole carriers in the PMOS devices. The same trend can be seen in the effective drain current, which shows a small decrease in the NMOS devices on the (110) substrate, but a more substantial increase for PMOS devices on the (110) substrate.

### Fabrication Methodology

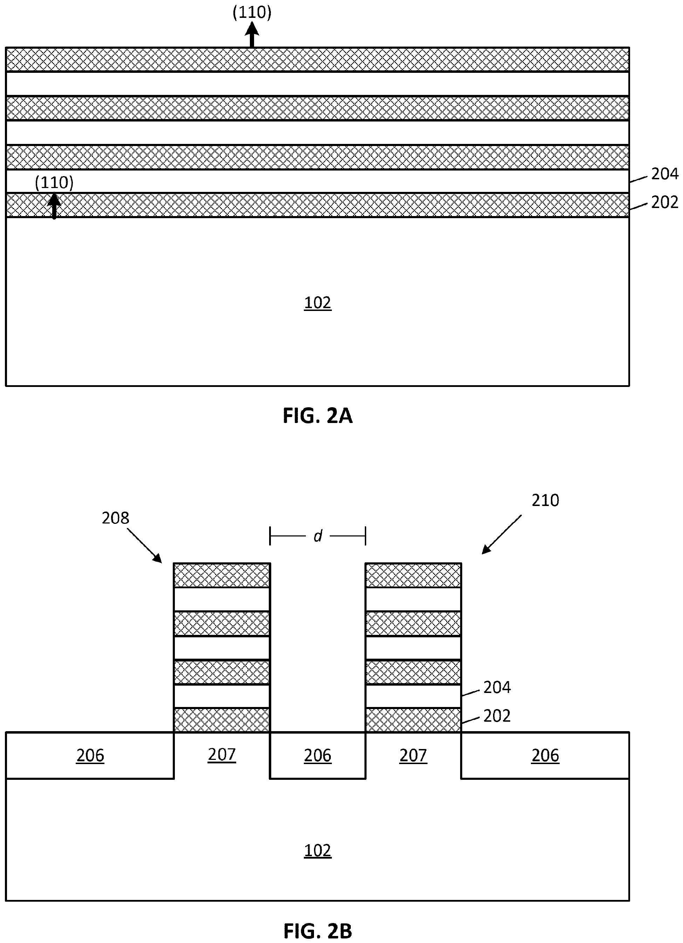

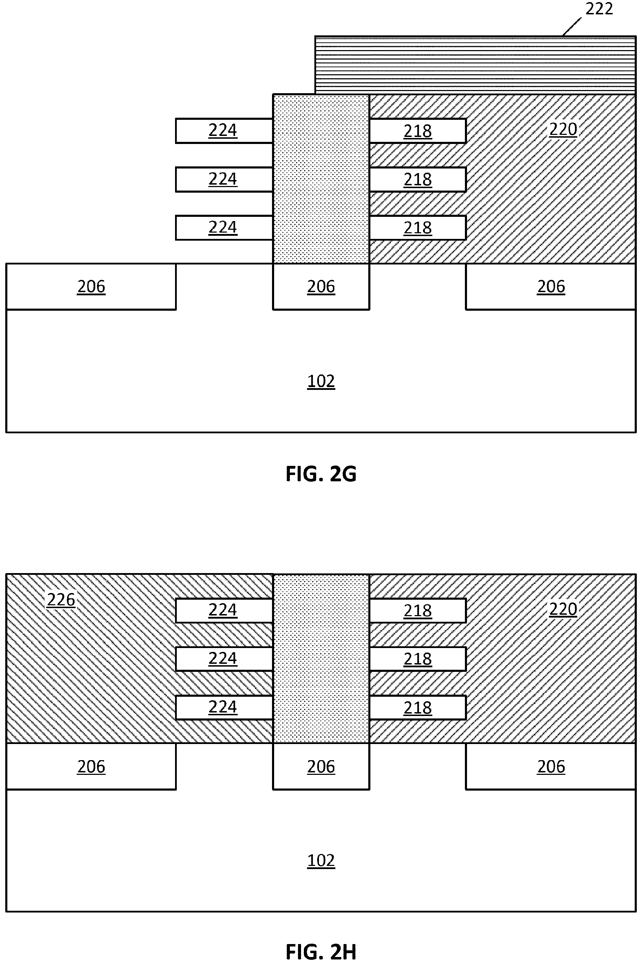

Figures 2A - 2H include cross-sectional views that collectively illustrate an example process for forming an integrated circuit configured with semiconductor devices in a forksheet configuration and formed on a (110) substrate, according to some embodiments. Each figure shows an example structure that results from the process flow up to that point in time, so the depicted structure evolves as the process flow continues, culminating in the structure shown in Figure 2H, which is similar to the structure shown in Figure 1A. The illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 2A illustrates a cross-sectional view across a substrate having a series of material layers deposited over it, according to an embodiment of the present disclosure. The previous relevant discussion with respect to example configurations and materials for substrate 102 is equally applicable here. Alternating material layers may be deposited over substrate 102, including sacrificial layers 202 alternating with semiconductor layers 204. Any number of alternating sacrificial layers 202 and semiconductor layers 204 may be deposited over substrate 102. In some embodiments, sacrificial layers 202 are silicon germanium (SiGe) while each of semiconductor layers 204 includes a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204.

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm). The thickness of each of semiconductor layers 204 may be about the same as the thickness of each sacrificial layer 202 (e.g., about 5-20 nm). Each of sacrificial layers 202, and semiconductor layers 204 may be deposited using any known material deposition technique, such as chemical vapor deposition (CVD), plasma-enhanced chemical vapor deposition (PECVD), physical vapor deposition (PVD), or atomic layer deposition (ALD).

As discussed above, substrate 102 has a (110) crystallographic surface orientation as identified by the bold arrow normal to the surface of substrate 102. The surface orientation of the silicon lattice affects the growth profile of each of the layers 202/204 formed on it. Thus, according to some embodiments, each of sacrificial layers 202 and semiconductor layers 204 similarly have a (110) crystallographic surface orientation along all surfaces that are parallel with the top surface of substrate 102.

Figure 2B illustrates a cross-sectional view of the structure shown in Figure 2A following the formation of semiconductor fins, according to an embodiment. Any number of fins can be patterned across the integrated circuit, but only two (as part of a forksheet transistor) are illustrated here for clarity. Each of semiconductor device 208 and 210 includes a semiconductor fin. The fins can include at least a portion (e.g., subfin portion) that is native to the substrate, as illustrated, or may be non-native to the substrate. Each of the illustrated fins includes a multi-layer structure having alternating sacrificial layers 202 and semiconductor layers 204. Numerous other configurations can be used, including fins included in integrated circuit sections other than memory or logic sections, such as analog mixed signal sections, input/output sections, radio frequency or transducer sections.

The fins may be formed by using a patterned hard mask layer or photoresist. According to some embodiments, the hard mask layer or photoresist protects the underlying material during a directional etching process, such as reactive ion etching (RIE). While dimensions can vary from one example embodiment to the next, the total height of the fins extending above the surface of substrate 102 may be in the range of about 100 nm to about 250 nm. The distance d between the adjacent fins of semiconductor devices 208 and 210 generally defines the width of the dielectric spine to be formed between the fins. According to some embodiments, the distance d is between about 10 nm and about 20 nm.

Following the etching process used to form the fins, a dielectric fill 206 is formed around the base of each of the fins, according to an embodiment. Dielectric fill 206 may act as shallow trench isolation (STI) between adjacent semiconductor devices. In some embodiments, dielectric fill 206 includes silicon oxide, although other oxides or dielectrics may be used as well. Dielectric fill 206 may first be deposited to at least the same height as the fins, and then recessed back using any known controlled etching process to the final height shown. According to some embodiments, each of the fins includes a subfin portion 207 beneath an exposed portion of the fin and between dielectric fill 206. The subfin portions 207 may include the same material as semiconductor substrate 102 and may be an integral part of semiconductor substrate 102. Following the formation of dielectric fill 206, the exposed fins extending above a top surface of dielectric fill 206 may have a height between about 50 nm and about 200 nm. The width of the fins can be, for example, in the range of about 5 nm to about 15 nm, such as 6 nm wide.

It should be noted that the fin fabrication process described with reference to Figures 2A and 2B is just one example process for forming multilayer fins. Other processes may be used as well, such as the aforementioned aspect ratio trapping based process.

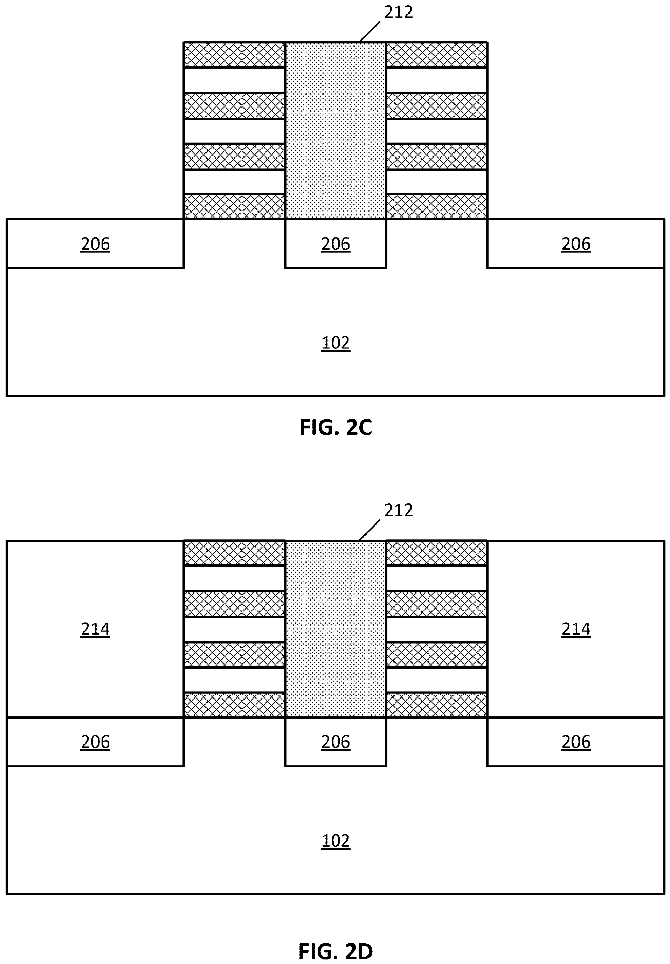

Figure 2C illustrates a cross-sectional view of the structure shown in Figure 2B following a formation of a dielectric spine 212 between the fins, according to an embodiment of the present disclosure. Briefly, a dielectric material may be blanket deposited across the structure and polished back to be level with the top surface of the fins. A masking layer may then be used to protect the dielectric material of dielectric spine 212 while removing the excess dielectric material on the opposite sides of the fins. According to some embodiments, dielectric spine 212 is the same material as dielectric fill 206. Dielectric spine 212 may be silicon oxide, to name one example.

Figure 2D illustrates a cross-sectional view of the structure shown in Figure 2C following the formation of sacrificial gate 214, according to an embodiment of the present disclosure. Sacrificial gate 214 may run in an orthogonal direction to the length of the fins (the fins run into and out of the page) and may include any material that can be selectively removed later in the process without etching or otherwise damaging any portions of the fin. In some embodiments, sacrificial gate 214 includes polysilicon. Sacrificial gate 214 may be initially deposited over both fins and over dielectric spine 212, and subsequently polished back until a top surface of sacrificial gate 214 is substantially planar with a top surface of the fins (e.g., within 1-2 nm). Although not illustrated in these cross-sections, spacer structures are also formed on the sidewalls of sacrificial gate 214. Sacrificial gate 214 and the sidewall spacer structures are used to define the lengths of the fins while remaining portions of the fins not protected by sacrificial gate 214 and the sidewall spacers are removed. The source and drain regions for each of the semiconductor devices may be formed at the ends of both of the fins.

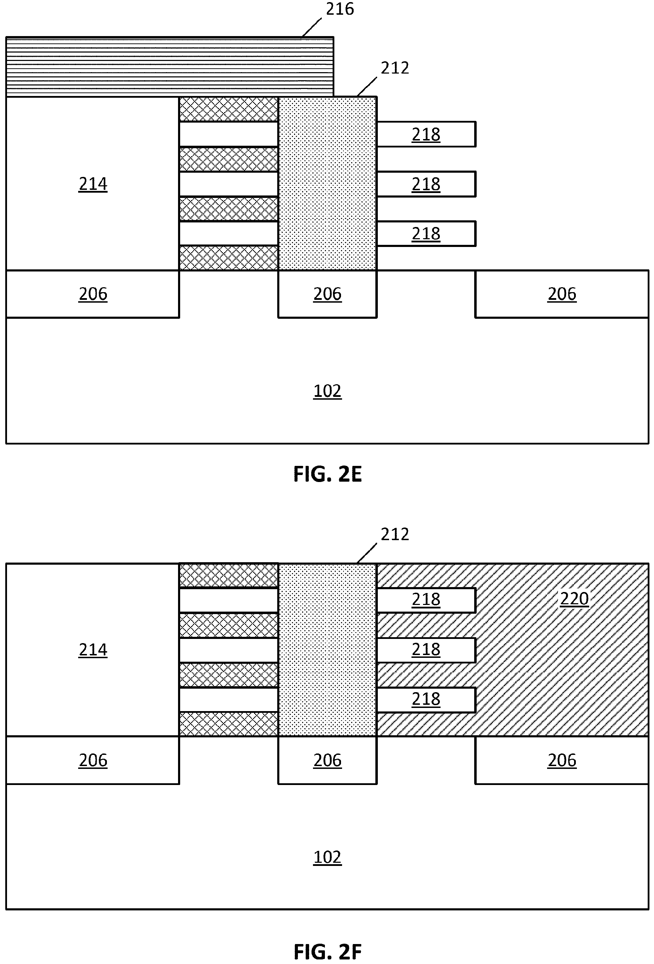

Figure 2E illustrates a cross-sectional view of the structure shown in Figure 2D following the removal of sacrificial layers 202 from one of the fins, according to an embodiment of the present disclosure. A mask layer 216 may be used to protect one fin while an isotropic etching process is used to remove sacrificial gate 214 adjacent to the other fin. Mask layer 216 may be a hard mask layer or a photoresist, such as a carbon hard mask (CHM) to name one example.

Sacrificial gate 214 may be removed using any wet or dry isotropic process thus exposing the alternating layer stack of the fin within the trench left behind after the removal of sacrificial gate 214. Once sacrificial gate structure 214 has been removed, sacrificial layers 202 may also be removed using a selective isotropic etching process that removes the material of sacrificial layers 202 but does not remove (or removes very little of) the semiconductor layers, resulting in one or more semiconductor nanosheets 218. At this point, the semiconductor nanoribbons extend between source and drain regions into and out of the page.

Figure 2F illustrates a cross-sectional view of the structure shown in Figure 2E following the formation of a first gate structure 220, according to an embodiment of the present disclosure. As noted above, first gate structure 220 includes a first gate dielectric and a first gate electrode.

The first gate dielectric may be conformally deposited around each of nanosheets 218 using any suitable deposition process, such as thermal oxidation and/or ALD. The first gate dielectric may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the first gate dielectric is hafnium oxide with a thickness between about 1 nm and about 5 nm. In some embodiments, the first gate dielectric may include one or more silicates (e.g., titanium silicate, tungsten silicate, niobium silicate, and silicates of other transition metals). The first gate dielectric may be a multilayer structure, in some examples. For instance, the first gate dielectric may include a first layer on nanosheets 218, and a second layer on the first layer. The first layer can be, for instance, an oxide of the semiconductor layers (e.g., silicon dioxide, provided by thermal oxidation or ALD) and the second layer can be a high-k dielectric material (e.g., hafnium oxide provided by ALD).

The first gate electrode may be deposited over the first gate dielectric and can be any standard or proprietary gate structure that may include any number of gate cuts. In some embodiments, the first gate electrode includes doped polysilicon, a metal, or a metal alloy. Example suitable metals or metal alloys include aluminum, tungsten, cobalt, molybdenum, ruthenium, titanium, tantalum, copper, and carbides and nitrides thereof. The first gate electrode may include, for instance, one or more work function layers, resistance-reducing layers, and/or barrier layers. The work function layers can include, for example, p-type work function materials (e.g., titanium nitride) for PMOS gates, or n-type work function materials (e.g., titanium aluminum carbide) for NMOS gates.

Figure 2G illustrates a cross-sectional view of the structure shown in Figure 2F following the removal of sacrificial layers 202 from the other fin, according to an embodiment of the present disclosure. A mask layer 222 may be used to protect one fin while an isotropic etching process is used to remove sacrificial gate 214 adjacent to the other fin. Mask layer 222 may be a hard mask layer or a photoresist, such as a carbon hard mask (CHM) to name one example. The process for removing sacrificial gate 214 and the sacrificial layers 202 is the same as described above with reference to Figure 2E. Removing the sacrificial layers results in one or more semiconductor nanosheets 224 that extend between source and drain regions into and out of the page.

Figure 2H illustrates a cross-sectional view of the structure shown in Figure 2G following the formation of a second gate structure 226, according to an embodiment of the present disclosure. Second gate structure 226 may be formed in substantially the same manner as described above for first gate structure 220 and similarly includes a second gate dielectric and a second gate electrode. According to some embodiments, second gate structure 226 includes p-type work function materials (e.g., titanium nitride) to create a PMOS gate while first gate structure 220 includes n-type work function materials (e.g., titanium aluminum carbide) to create a NMOS gate.

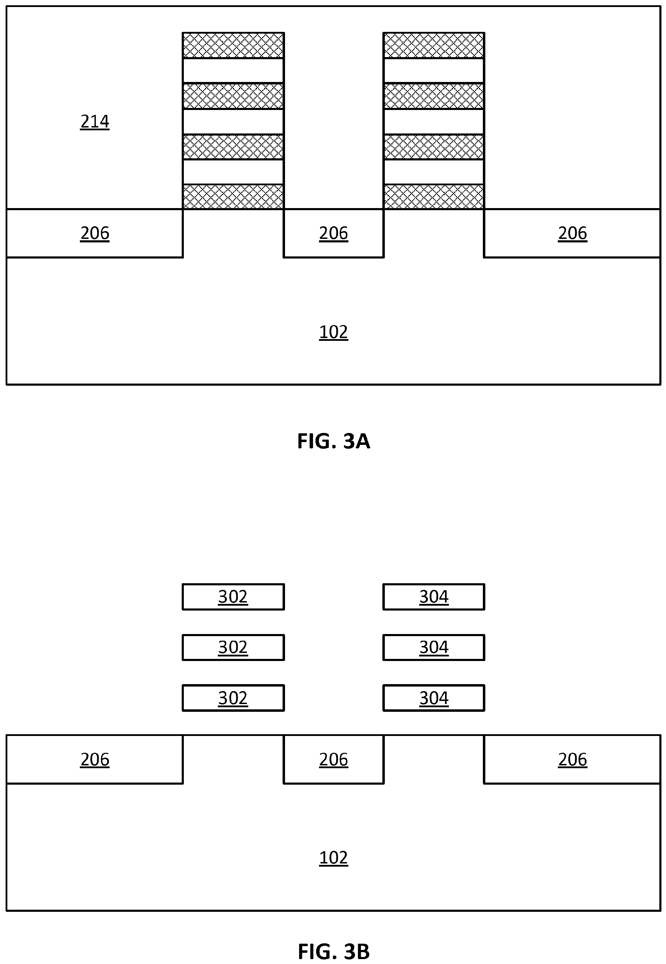

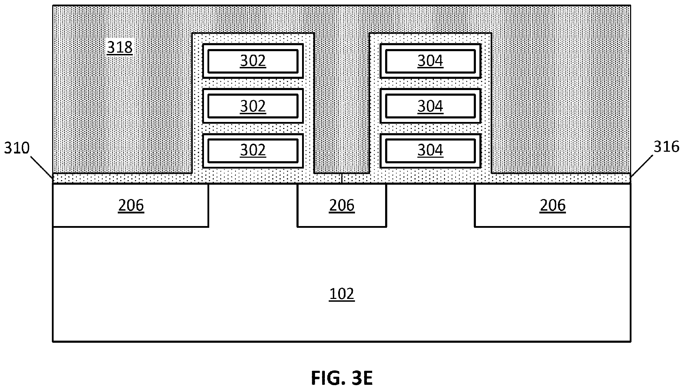

Figures 3A - 3E include cross-sectional views that collectively illustrate an example process for forming an integrated circuit configured with semiconductor devices having a shared gate CMOS configuration and formed on a (110) substrate, according to some embodiments. Each figure shows an example structure that results from the process flow up to that point in time, so the depicted structure evolves as the process flow continues, culminating in the structure shown in Figure 3E, which is similar to the structure shown in Figure 1A without the dielectric spine between the fins. The illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 3A illustrates two adjacent multilayer fins with sacrificial gate 214 formed across the two fins. According to some embodiments, the structure depicted in Figure 3A is very similar to the structure illustrated in Figure 2D, but without the dielectric spine between the fins. Thus, the fabrication procedure for forming each of the two fins and dielectric fill 206 is the same as previously described with reference to Figures 2A and 2B. Accordingly, each of the material layers within both fins have a (110) crystallographic surface orientation along all surfaces that are parallel with the top surface of substrate 102. In some embodiments, the distance between the two fins may be larger than previously described since the dielectric spine is not being used in this configuration.

Figure 3B illustrates a cross-sectional view of the structure shown in Figure 3A following the removal of sacrificial layers 202 from each of the fins and the removal of sacrificial gate 214, according to an embodiment of the present disclosure. Sacrificial gate 214 may be removed using any wet or dry isotropic process thus exposing the alternating layer stack of the fins within the trench left behind after the removal of sacrificial gate 214. Once sacrificial gate 214 has been removed, sacrificial layers 202 may also be removed from each fin using a selective isotropic etching process that removes the material of sacrificial layers 202 but does not remove (or removes very little of) the semiconductor layers, resulting in a first set of suspended semiconductor nanoribbons 302 and a second set of suspended semiconductor nanoribbons 304. Each of first set of semiconductor nanoribbons 302 and second set of semiconductor nanoribbons 304 extend between corresponding source and drain regions into and out of the page.

According to some embodiments, the source and drain regions coupled to first set of semiconductor nanoribbons 302 may have a different doping and/or different material composition compared to the source and drain regions coupled to second set of semiconductor nanoribbons 304. First set of semiconductor nanoribbons 302 may be nanoribbons of a PMOS device while second set of semiconductor nanoribbons 304 may be nanoribbons of an NMOS device, or vice versa.

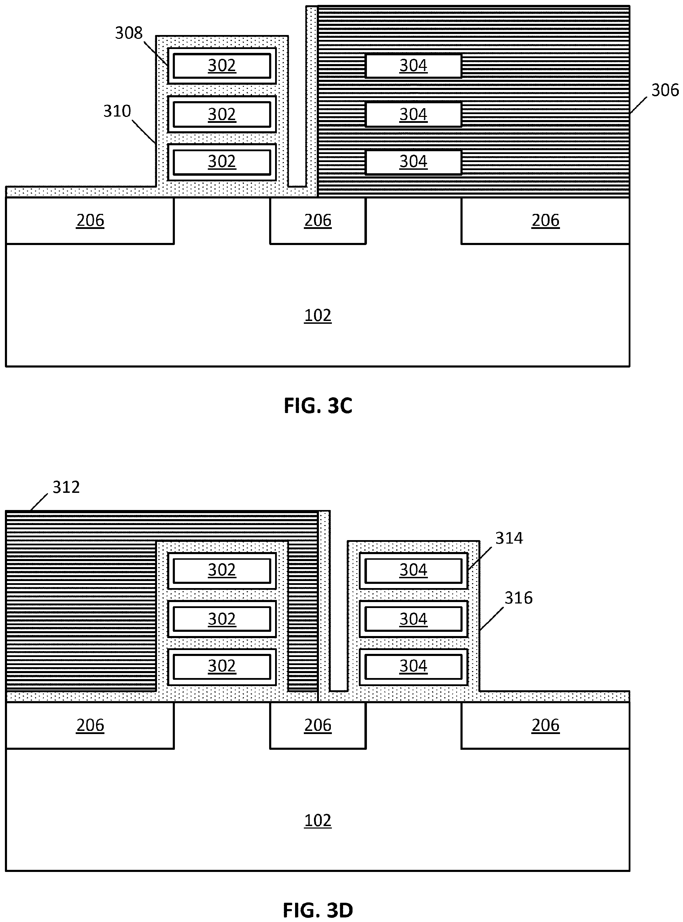

Figure 3C illustrates a cross-sectional view of the structure shown in Figure 3B following the formation of a masking layer 306 to mask one set of nanoribbons while gate structure layers are formed over the other set of nanoribbons, according to an embodiment of the present disclosure. In this example, masking layer 306 is formed over second set of nanoribbons 304 while leaving exposed first set of nanoribbons 302. Masking layer 306 may be a hard mask material, such as CHM or a photoresist.

According to some embodiments, a first gate dielectric 308 is formed around each of first set of nanoribbons 302. First gate dielectric 308 may also form along the exposed bottom of the trench and along the sidewall of masking layer 306. First gate dielectric 308 may be conformally deposited around each of first set of nanoribbons 302 using any suitable deposition process, such as thermal oxidation and/or ALD. First gate dielectric 308 may include any number of layers having any suitable dielectric (such as silicon dioxide, and/or a high-k dielectric material). In general, first gate dielectric 308 may be similar to the first gate dielectric described above with reference to Figure 2F.

Following the formation of first gate dielectric 308, a first work function layer 310 is formed over first gate dielectric 308, according to some embodiments. First work function layer 310 may include any suitable work function metal for use in a PMOS device. An example work function metal for a PMOS device includes titanium nitride. In some examples, first work function layer 310 fills any remaining space between adjacent ones of first set of nanoribbons 302. First work function layer 310 may also form along the sidewall of masking layer 306.

Figure 3D illustrates a cross-sectional view of the structure shown in Figure 3C following the formation of another masking layer 312 around first set of nanoribbons 302 while gate structure layers are formed over second set of nanoribbons 304, according to an embodiment of the present disclosure. Masking layer 312 may similarly be a hard mask material, such as CHM or a photoresist. In some examples, masking layer 312 is not needed as first set of nanoribbons 302 can be protected by the gate structure layers already formed around them. It should be noted that the removal of masking layer 306 may also remove the portion of first work function layer 310 that had formed along the sidewall of masking layer 306.

According to some embodiments, a second gate dielectric 314 is formed around each of second set of nanoribbons 304. Second gate dielectric 314 may also form along the exposed bottom of the trench and along the sidewall of masking layer 312. Second gate dielectric 314 may be conformally deposited around each of second set of nanoribbons 304 using any suitable deposition process, such as thermal oxidation and/or ALD. Second gate dielectric 314 may include any number of layers having any suitable dielectric (such as silicon dioxide, and/or a high-k dielectric material). In general, second gate dielectric 314 may be similar to the first gate dielectric described above with reference to Figure 2F.

Following the formation of second gate dielectric 314, a second work function layer 316 is formed over second gate dielectric 314, according to some embodiments. Second work function layer 316 may include any suitable work function metal for use in a NMOS device. An example work function metal for a NMOS device includes titanium aluminum carbide. In some examples, second work function layer 316 fills any remaining space between adjacent ones of second set of nanoribbons 304. Second work function layer 316 may also form along the sidewall of masking layer 312. It should be understood that either first or second sets of nanoribbons 302/304 may be part of an NMOS device or a PMOS device with corresponding work function layers for an NMOS or PMOS device.

Figure 3E illustrates a cross-sectional view of the structure shown in Figure 3D following the formation of a fill metal 318 to complete the gate electrode around each of first set of nanoribbons 302 and second set of nanoribbons 304, according to an embodiment of the present disclosure. Fill metal 318 may be formed around each of first work function layer 310 and second work function layer 316, such that fill metal 318 fills the remainder of the trench around the semiconductor devices. Fill metal 318 may include tungsten (W) or a combination of titanium nitride (TiN) and tungsten, to name a few examples.

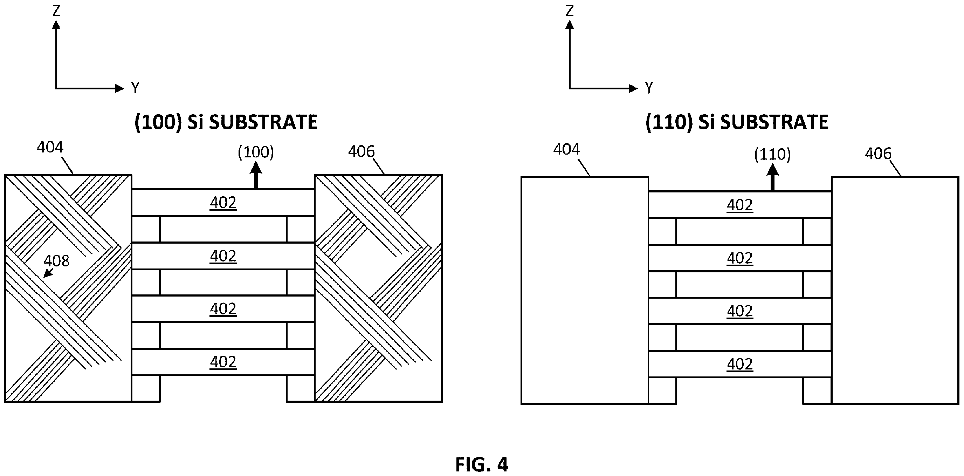

Figure 4 illustrates example cross-sections taken along the length of nanoribbons or nanosheets 402 extending between a source region 404 and a drain region 406 for different substrate crystallographic surface orientations. The cross-sections are taken along the first direction (e.g., Y-direction) and along the third direction (e.g., Z-direction). In the example of a (100) substrate, nanoribbons or nanosheets 402 exhibit a similar (100) surface orientation. The epitaxial growth of source region 404 and drain region 406 from the ends of nanoribbons or nanosheets 402 having the (100) orientation exhibit a crystalline growth profile showing facets 408 along the illustrated cross-section (e.g., across a plane that runs along the length of nanoribbons or nanosheets 402 and along a vector that is normal to the top surface of the substrate). Any number of facets 408 may be visible. In contrast, source region 404 and drain region 406 exhibit no visible facets along the same cross-section when grown from the ends of nanoribbons 402 having a (110) surface orientation. The facets may be visible along other planes since the crystalline growth of the source region 404 and drain region 406 is along a different direction due to the difference in the crystallographic surface orientation of nanoribbons or nanosheets 402. So, for example, the source region 404 and the drain region 406 nucleated from nanoribbons or nanosheets 402 having a (100) surface orientation have visible crystal facets along a cross-section that extends along the Y-direction and the Z-direction, and the source region 404 and the drain region 406 nucleated from nanoribbons or nanosheets 402 having a (110) surface orientation have no visible crystal facets along that same cross-section which extends along the Y-direction and the Z-direction (Y being orthogonal to Z).

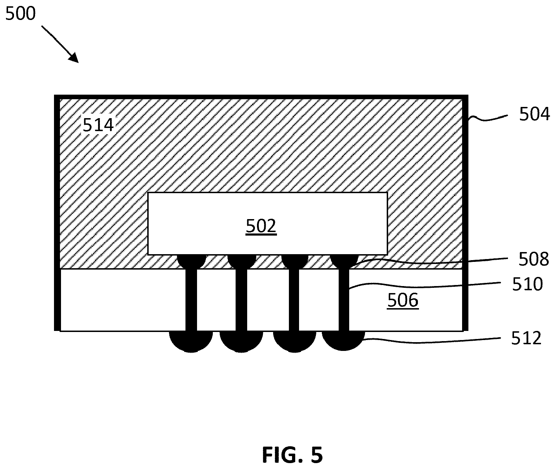

Figure 5 illustrates an example embodiment of a chip package 500, in accordance with an embodiment of the present disclosure. As can be seen, chip package 500 includes one or more dies 502. One or more dies 502 may include at least one integrated circuit having semiconductor devices, such as any of the semiconductor devices disclosed herein. One or more dies 502 may include any other circuitry used to interface with other devices formed on the dies, or other devices connected to chip package 500, in some example configurations.

As can be further seen, chip package 500 includes a housing 504 that is bonded to a package substrate 506. The housing 504 may be any standard or proprietary housing, and may provide, for example, electromagnetic shielding and environmental protection for the components of chip package 500. The one or more dies 502 may be conductively coupled to a package substrate 506 using connections 508, which may be implemented with any number of standard or proprietary connection mechanisms, such as solder bumps, ball grid array (BGA), pins, or wire bonds, to name a few examples. Package substrate 506 may be any standard or proprietary package substrate, but in some cases includes a dielectric material having conductive pathways (e.g., including conductive vias and lines) extending through the dielectric material between the faces of package substrate 506, or between different locations on each face. In some embodiments, package substrate 506 may have a thickness less than 1 millimeter (e.g., between 0.1 millimeters and 0.5 millimeters), although any number of package geometries can be used. Additional conductive contacts 512 may be disposed at an opposite face of package substrate 506 for conductively contacting, for instance, a printed circuit board (PCB). One or more vias 510 extend through a thickness of package substrate 506 to provide conductive pathways between one or more of connections 508 to one or more of contacts 512. Vias 510 are illustrated as single straight columns through package substrate 506 for ease of illustration, although other configurations can be used (e.g., damascene, dual damascene, through-silicon via, or an interconnect structure that meanders through the thickness of substrate 506 to contact one or more intermediate locations therein). In still other embodiments, vias 510 are fabricated by multiple smaller stacked vias, or are staggered at different locations across package substrate 506. In the illustrated embodiment, contacts 512 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 512, to inhibit shorting.

In some embodiments, a mold material 514 may be disposed around the one or more dies 502 included within housing 504 (e.g., between dies 502 and package substrate 506 as an underfill material, as well as between dies 502 and housing 504 as an overfill material). Although the dimensions and qualities of the mold material 514 can vary from one embodiment to the next, in some embodiments, a thickness of mold material 514 is less than 1 millimeter. Example materials that may be used for mold material 514 include epoxy mold materials, as suitable. In some cases, the mold material 514 is thermally conductive, in addition to being electrically insulating.

### Methodology

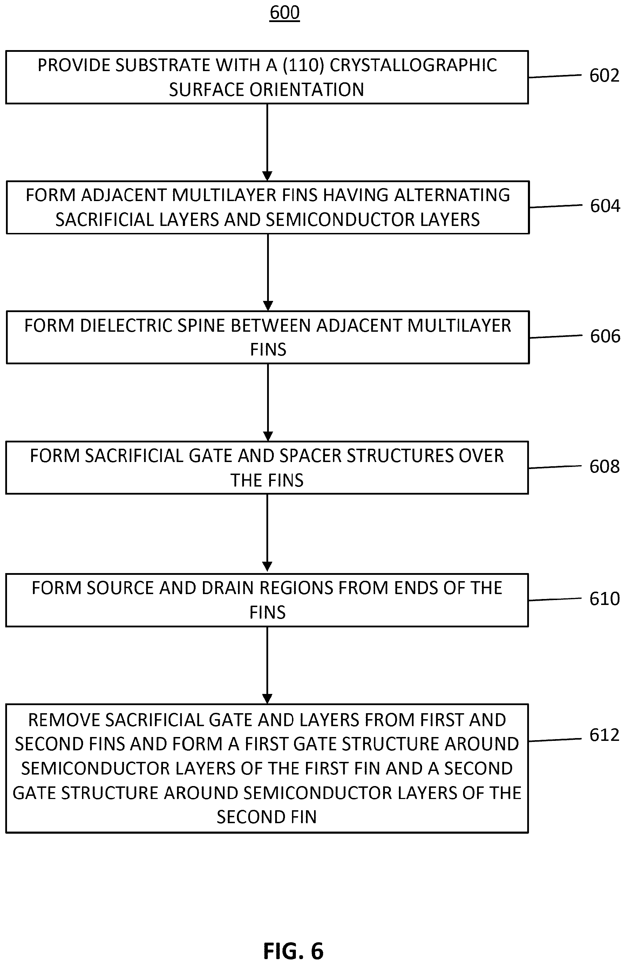

Figure 6 is a flow chart of a method 600 for forming at least a portion of an integrated circuit, according to an embodiment. Various operations of method 600 may be illustrated in Figures 2A - 2H. However, the correlation of the various operations of method 600 to the specific components illustrated in the aforementioned figures is not intended to imply any structural and/or use limitations. Rather, the aforementioned figures provide one example embodiment of method 600. Other operations may be performed before, during, or after any of the operations of method 600. For example, method 600 does not explicitly describe many steps that are performed to form common transistor structures. Some of the operations of method 600 may be performed in a different order than the illustrated order.

Method 600 begins with operation 602 where a substrate is provided that has a (110) crystallographic surface orientation. The substrate may be a bulk silicon substrate or an SOI substrate with a top silicon layer having the (110) crystallographic surface orientation.

Method 600 continues with operation 604 where adjacent parallel fins are formed. Each of the adjacent fins may include alternating sacrificial layers (e.g., comprising SiGe) and semiconductor layers (e.g., comprising Si, SiGe, Ge, InP, or GaAs). The thickness of each of the sacrificial layers and semiconductor layers may be between about 5 nm and about 20 nm or between about 5 nm and about 10 nm. Each of layers may be deposited using any known material deposition technique, such as CVD, PECVD, PVD, or ALD. Once all layers have been deposited over a substrate, the adjacent fins may be defined through the layer stack via an anisotropic etching process, such as RIE, using a patterned mask material to protect the fins from the etch. The total fin height may include the alternating material layers and a subfin portion formed from the substrate material. In some other embodiments, trenches are first formed in a dielectric material and the alternating material layers are formed within the trenches to form one or more multilayer fins. A distance between the adjacent parallel fins defines a width of the dielectric spine to be formed between the fins.

Method 600 continues with operation 606 where a dielectric spine is formed between the fins. In some embodiments, a dielectric layer may be blanket deposited over and around the fins, including between the fins. The dielectric layer may then be polished back to expose the top surfaces of the fins and the dielectric material between the fins can be protected by a mask layer while the exposed portions of the dielectric layer are removed from around the fins. The remaining portion of the dielectric layer beneath the mask layer provides the dielectric spine between the fins.

Method 600 continues with operation 608 where a sacrificial gate and spacer structures are formed over the fins. The sacrificial gate may run in an orthogonal direction to the length of the fins and may include any material that can be selectively removed later in the process without etching or otherwise damaging any portions of the fin. In some embodiments, the sacrificial gate includes polysilicon. The sacrificial gate may be initially deposited over both fins and over the dielectric spine and overhang structures, and subsequently polished back until a top surface of the sacrificial gate is substantially planar with a top surface of the overhang structures. The sidewall spacer structures may include any dielectric material and are used (along with the sacrificial gate) to define the lengths of the fins while remaining portions of the fins not protected by the sacrificial gate and the sidewall spacers are removed.

Method 600 continues with operation 610 where source and drain regions are formed at corresponding ends of each of the fins. According to some embodiments, the source and drain regions are epitaxial regions that are provided using an etch-and-replace process. Any semiconductor materials suitable for source and drain regions can be used (e.g., group IV and group III-V semiconductor materials). The source and drain regions may include multiple layers such as liners and capping layers to improve contact resistance. In any such cases, the composition and doping of the source and drain regions may be the same or different, depending on the polarity of the transistors.

According to some embodiments, since the nanoribbons themselves follow the crystallographic orientation of the substrate, the growth profile of the source and drain regions is also affected by the different substrate orientation. Thus, the source and drain regions will exhibit crystal facets having different orientations when grown over a (110) substrate as compared to source and drain regions grown over a (100) substrate. For example, source and drain regions formed over a (100) substrate exhibit crystal facets along a cross-section taken through the source and drain regions that runs along a length of the nanoribbons (in a first direction) and along a vector that is normal to the surface of the substrate (in a third direction). In contrast, source and drain regions formed over a (110) substrate do not exhibit crystal facets along the same cross-section taken through the source and drain regions.

Method 600 continues with operation 612 where the sacrificial gate is replaced with a first gate structure over the semiconductor layers of the first fin and a second gate structure over the semiconductor material of the second fin. Each of the first gate structure and the second gate structure includes a gate dielectric and a gate electrode. The gate dielectric of each gate structure may be conformally deposited first around the semiconductor material of the corresponding fin using any suitable deposition process, such as ALD. The gate dielectrics may include any suitable dielectric (such as silicon dioxide, and/or a high-k dielectric material). According to some embodiments, the gate dielectrics include hafnium oxide with a thickness between about 1 nm and about 5 nm. In some embodiments, the gate dielectrics may include one or more silicates (e.g., titanium silicate, tungsten silicate, niobium silicate, and silicates of other transition metals). Either of the gate dielectrics may be a multilayer structure, in some examples.

The gate electrodes of each of gate structure may be deposited over the corresponding gate dielectric and can be any standard or proprietary conductive structure that may include any number of gate cuts. In some embodiments, the gate electrodes include doped polysilicon, a metal, or a metal alloy. Example suitable metals or metal alloys include aluminum, tungsten, cobalt, molybdenum, ruthenium, titanium, tantalum, copper, and carbides and nitrides thereof. The gate electrodes may include, for instance, one or more work function layers, resistance-reducing layers, and/or barrier layers. The work function layers can include, for example, p-type work function materials (e.g., titanium nitride) for PMOS gates, or n-type work function materials (e.g., titanium aluminum carbide) for NMOS gates.

### Example System

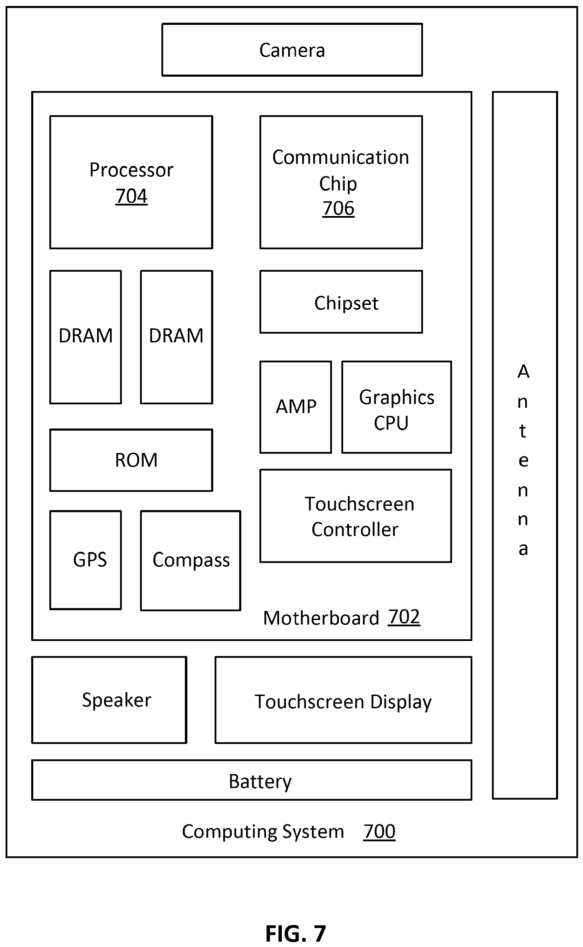

FIG. 7 is an example computing system implemented with one or more of the integrated circuit structures as disclosed herein, in accordance with some embodiments of the present disclosure. As can be seen, the computing system 700 houses a motherboard 702. The motherboard 702 may include a number of components, including, but not limited to, a processor 704 and at least one communication chip 706, each of which can be physically and electrically coupled to the motherboard 702, or otherwise integrated therein. As will be appreciated, the motherboard 702 may be, for example, any printed circuit board (PCB), whether a main board, a daughterboard mounted on a main board, or the only board of system 700, etc.

Depending on its applications, computing system 700 may include one or more other components that may or may not be physically and electrically coupled to the motherboard 702. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 700 may include one or more integrated circuit structures or devices configured in accordance with an example embodiment (e.g., a module including an integrated circuit on a substrate, the substrate having a (110) crystallographic surface orientation). In some embodiments, multiple functions can be integrated into one or more chips (e.g., for instance, note that the communication chip 706 can be part of or otherwise integrated into the processor 704).

The communication chip 706 enables wireless communications for the transfer of data to and from the computing system 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 706 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing system 700 includes an integrated circuit die packaged within the processor 704. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 706 also may include an integrated circuit die packaged within the communication chip 706. In accordance with some such example embodiments, the integrated circuit die of the communication chip includes one or more semiconductor devices as variously described herein. As will be appreciated in light of this disclosure, note that multi-standard wireless capability may be integrated directly into the processor 704 (e.g., where functionality of any chips 706 is integrated into processor 704, rather than having separate communication chips). Further note that processor 704 may be a chip set having such wireless capability. In short, any number of processor 704 and/or communication chips 706 can be used. Likewise, any one chip or chip set can have multiple functions integrated therein.

In various implementations, the computing system 700 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 700 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a substrate having a (110) crystallographic surface orientation, a semiconductor device on the substrate and having one or more bodies of semiconductor material extending in a first direction from a source region to a drain region, a first spacer structure that extends in a second direction orthogonal to the first direction and around first ends of the one or more bodies of semiconductor material, a second spacer structure that extends in the second direction and around second ends of the one or more bodies of semiconductor material, and a gate structure at least partially around the one or more bodies of semiconductor material and between the first and second spacer structures. The one or more bodies of semiconductor material have a (110) crystallographic surface orientation along surfaces that are parallel with a plane extending along the first direction and the second direction.

Example 2 includes the subject matter of Example 1, wherein the source region and the drain region do not have visible crystal facets along a cross-section through the source region and the drain region, the cross-section extending along the first direction and a third direction, the third direction orthogonal to both the first direction and the second direction.

Example 3 includes the subject matter of Example 1 or 2, wherein the semiconductor device is a first semiconductor device having one or more first bodies of semiconductor material, the integrated circuit further comprising a second semiconductor device on the substrate and having one or more second bodies of semiconductor material extending in the first direction from another source region to another drain region, wherein the first semiconductor device is an NMOS device and the second semiconductor device is a PMOS device.

Example 4 includes the subject matter of Example 3, wherein the one or more second bodies of semiconductor material have a (110) crystallographic surface orientation along surfaces that are parallel with a plane extending along the first direction and the second direction.

Example 5 includes the subject matter of Example 3 or 4, further comprising a dielectric spine between the one or more first bodies of semiconductor material and the one or more second bodies of semiconductor material, such that the one or more first bodies of semiconductor material abut a first side of the dielectric spine and the one or more second bodies of semiconductor material abut a second side of the dielectric spine.

Example 6 includes the subject matter of any one of Examples 1-5, wherein the gate structure includes a gate dielectric on each of the one or more bodies of semiconductor material and a gate electrode on the gate dielectric.

Example 7 includes the subject matter of Example 6, wherein the gate dielectric includes a layer of high-k dielectric material.

Example 8 includes the subject matter of any one of Examples 1-7, wherein the one or more bodies of semiconductor material are nanoribbons or nanosheets.

Example 9 is a printed circuit board comprising the integrated circuit of any one of Examples 1-8.

Example 10 is an electronic device that includes a chip package comprising one or more dies. At least one of the one or more dies includes a substrate having a (110) crystallographic surface orientation, a semiconductor device on the substrate and having one or more semiconductor nanoribbons extending in a first direction from a source region to a drain region, a first spacer structure that extends in a second direction orthogonal to the first direction and around first ends of the one or more semiconductor nanoribbons, a second spacer structure that extends in the second direction and around second ends of the one or more semiconductor nanoribbons, and a gate structure at least partially around the one or more semiconductor nanoribbons and between the first and second spacer structures. The source region and the drain region do not have visible crystal facets along a cross-section through the source region and the drain region, the cross-section extending along the first direction and a third direction, the third direction being orthogonal to both the first direction and the second direction.

Example 11 includes the subject matter of Example 10, wherein the one or more semiconductor nanoribbons have a (110) crystallographic surface orientation along surfaces that are parallel with a plane extending along the first direction and the second direction.

Example 12 includes the subject matter of Example 10 or 11, wherein the semiconductor device is a first semiconductor device having one or more first semiconductor nanoribbons, the at least one of the one or more dies further comprising a second semiconductor device on the substrate and having one or more second semiconductor nanoribbons extending in the first direction from another source region to another drain region, wherein the first semiconductor device is an NMOS device and the second semiconductor device is a PMOS device.

Example 13 includes the subject matter of Example 12, wherein the one or more second semiconductor nanoribbons have a (110) crystallographic surface orientation along surfaces that are parallel with a plane extending along the first direction and the second direction.

Example 14 includes the subject matter of Example 12 or 13, wherein the at least one of the one or more dies further comprises a dielectric spine between the one or more first semiconductor nanoribbons and the one or more second semiconductor nanoribbons, such that the one or more first semiconductor nanoribbons abut a first side of the dielectric spine and the one or more second semiconductor nanoribbons abut a second side of the dielectric spine.

Example 15 includes the subject matter of any one of Examples 10-14, wherein the gate structure includes a gate dielectric on each of the one or more semiconductor nanoribbons and a gate electrode on the gate dielectric.

Example 16 includes the subject matter of Example 15, wherein the gate dielectric includes a layer of high-k dielectric material.

Example 17 includes the subject matter of any one of Examples 10-16, further comprising a printed circuit board, wherein the chip package is attached to the printed circuit board.

Example 18 is a method of forming an integrated circuit. The method includes providing a substrate having a (110) crystallographic surface orientation; epitaxially growing first material layers alternating with second material layers on the substrate, the second material layers comprising silicon (Si); forming a multilayer fin from the first material layers and the second material layers; forming sidewall spacer structures around exposed ends of the second material layers; removing the first material layers to form suspended second material layers; forming source and drain regions coupled to the exposed ends of the second material layers, such that the source and drain regions do not have visible crystal facets along a cross-section, the cross-section running along a length of the suspended second material layers and along a vector normal to a top surface of the substrate; and forming a gate structure around the suspended second material layers and between the sidewall spacer structures.

Example 19 includes the subject matter of Example 18, wherein the first material layers comprise Si and germanium (Ge).

Example 20 includes the subject matter of Example 18 or 19, wherein the second material layers have the same (110) crystallographic surface orientation as the substrate.

Example 21 is an integrated circuit that includes a semiconductor device having one or more semiconductor nanoribbons extending in a first direction between a source region and a drain region, a first spacer structure that extends in a second direction orthogonal to the first direction and around first ends of the one or more semiconductor nanoribbons, a second spacer structure that extends in the second direction and around second ends of the one or more semiconductor nanoribbons, and a gate structure at least partially around the one or more semiconductor nanoribbons and between the first and second spacer structures. Each of the one or more semiconductor nanoribbons has a (110) crystallographic surface orientation along surfaces that are parallel with a plane extending in the first direction and the second direction. The source region and the drain region do not have visible crystal facets along a cross-section taken through the source region and the drain region, the cross-section extending along the first direction and a third direction, the third direction being orthogonal to both the first direction and the second direction.

Example 22 includes the subject matter of Example 21, further comprising a substrate having a (110) crystallographic surface orientation.

Example 23 includes the subject matter of Example 21 or 22, wherein the semiconductor device is a first semiconductor device having one or more first semiconductor nanoribbons, the integrated circuit further comprising a second semiconductor device having one or more second semiconductor nanoribbons extending in the first direction between another source region and another drain region, wherein the first semiconductor device is an NMOS device and the second semiconductor device is a PMOS device.

Example 24 includes the subject matter of Example 23, wherein the one or more second semiconductor nanoribbons have a (110) crystallographic surface orientation along surfaces that are parallel with a plane extending along the first direction and the second direction.

Example 25 includes the subject matter of Example 23 or 24, further comprising a dielectric spine between the one or more first semiconductor nanoribbons and the one or more second semiconductor nanoribbons, such that the one or more first semiconductor nanoribbons abut a first side of the dielectric spine and the one or more second semiconductor nanoribbons abut a second side of the dielectric spine.

Example 26 includes the subject matter of any one of Examples 21-25, wherein the gate structure includes a gate dielectric layer on each of the one or more semiconductor nanoribbons and a gate electrode on the gate dielectric layer.

Example 27 includes the subject matter of Example 26, wherein the gate dielectric layer includes a high-k dielectric material.

Example 28 is a printed circuit board comprising the integrated circuit of any one of Examples 21-27.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a substrate having a (110) crystallographic surface orientation;
a semiconductor device on the substrate, the semiconductor device having one or more bodies of semiconductor material extending in a first direction from a source region to a drain region;
a first spacer structure that extends in a second direction orthogonal to the first direction and around first ends of the one or more bodies of semiconductor material;
a second spacer structure that extends in the second direction and around second ends of the one or more bodies of semiconductor material; and
a gate structure at least partially around the one or more bodies of semiconductor material and between the first and second spacer structures;
wherein the one or more bodies of semiconductor material have a (110) crystallographic surface orientation along surfaces that are parallel with a plane extending along the first direction and the second direction.

2. The integrated circuit of claim 1, wherein the source region and the drain region do not have visible crystal facets along a cross-section through the source region and the drain region, the cross-section extending along the first direction and a third direction, the third direction orthogonal to both the first direction and the second direction.

3. The integrated circuit of claim 1 or 2, wherein the semiconductor device is a first semiconductor device having one or more first bodies of semiconductor material, the integrated circuit further comprising a second semiconductor device on the substrate and having one or more second bodies of semiconductor material extending in the first direction from another source region to another drain region, wherein the first semiconductor device is an NMOS device and the second semiconductor device is a PMOS device.

4. The integrated circuit of claim 3, wherein the one or more second bodies of semiconductor material have a (110) crystallographic surface orientation along surfaces that are parallel with a plane extending along the first direction and the second direction.

5. The integrated circuit of claim 3 or 4, further comprising a dielectric spine between the one or more first bodies of semiconductor material and the one or more second bodies of semiconductor material, such that the one or more first bodies of semiconductor material abut a first side of the dielectric spine and the one or more second bodies of semiconductor material abut a second side of the dielectric spine.

6. The integrated circuit of any one of claims 1 through 5, wherein the gate structure includes a gate dielectric on each of the one or more bodies of semiconductor material and a gate electrode on the gate dielectric.

7. The integrated circuit of claim 6, wherein the gate dielectric includes a layer of high-k dielectric material.

8. The integrated circuit of claim 1, wherein the one or more bodies of semiconductor material are nanoribbons or nanosheets.

9. A printed circuit board comprising the integrated circuit of claim 1.

10. A method of forming an integrated circuit, comprising:
providing a substrate having a (110) crystallographic surface orientation;
epitaxially growing first material layers alternating with second material layers on the substrate, the second material layers comprising silicon (Si);
forming a multilayer fin from the first material layers and the second material layers;
forming sidewall spacer structures around exposed ends of the second material layers;
removing the first material layers to form suspended second material layers;
forming source and drain regions coupled to the exposed ends of the second material layers, such that the source and drain regions do not have visible crystal facets along a cross-section, the cross-section running along a length of the suspended second material layers and along a vector normal to a top surface of the substrate; and
forming a gate structure around the suspended second material layers and between the sidewall spacer structures.

11. The method of claim 10, wherein the first material layers comprise Si and germanium (Ge).

12. The method of claim 10 or 11, wherein the second material layers have the same (110) crystallographic surface orientation as the substrate.
